# EUROPEAN PATENT APPLICATION

(11) **EP 3 522 208 A1**
(43) Date of publication of application: **07.08.2019**
(21) Application number: 17855295.6
(22) Date of filing: 13.06.2017
(51) Int. Cl.: H01L 21/683, C23C 14/50, C23C 16/458, C23C 16/46, H01L 21/3065, H01L 21/31, H05H 1/46

(54) **SUBSTRATE PLACEMENT STAGE, AND SUBSTRATE PLACEMENT STAGE FABRICATION METHOD**

(30) Priority: 29.09.2016 JP 2016190661
(71) Applicant: NHK Spring Co., Ltd., Yokohama-shi, Kanagawa 236-0004 (JP)
(72) Inventor: TACHIKAWA Toshihiro, Yokohama-shi Kanagawa 236-0004 (JP); AIKAWA Naoya, Yokohama-shi Kanagawa 236-0004 (JP); TAKAHARA Go, Yokohama-shi Kanagawa 236-0004 (JP); SUZUKI Kohei, Yokohama-shi Kanagawa 236-0004 (JP); MITSUDA Hiroshi, Yokohama-shi Kanagawa 236-0004 (JP)
(74) Representative: dompatent von Kreisler Selting Werner - Partnerschaft von Patent- und Rechtsanwälten mbB
(86) International application number: PCT/JP2017/021788
(87) International publication number: WO 2018/061336

(57) **Abstract**

Provided is a stage for precisely controlling a substrate temperature and a manufacturing method thereof. Alternatively, a film-forming apparatus or a film-processing apparatus having the stage is provided. The stage includes a base material and a heater layer over the base material. The heater layer has a first insulating film, a heater wire over the first insulating film, and a second insulating film over the heater wire. The heater wire includes more than one kind of metal selected from tungsten, nickel. chromium cobalt, and molybdenum.

## Description

### FIELD

The present invention relates to a substrate-placing stage or a film-processing apparatus and a film-formation apparatus having the substrate-placing stage.

### BACKGROUND

A semiconductor device is mounted in almost all electronic devices and possesses important roles for the functions of the electronic devices. A semiconductor device utilizes the semiconductor properties of silicon or the like and is composed of a variety of thin films of an insulator and a conductor in addition to a semiconductor. Formation and processing of these thin films are carried out by a photolithography process. A photolithography process generally includes forming a thin film utilizing an evaporation method, a sputtering method, a chemical vapor deposition (CVD) method, or a chemical reaction of a substrate, preparing a resist mask by forming a resist film over the thin film followed by light-exposure and development, partially removing the thin film with etching, and removing the resist film.

In each step of a photolithography process, many reaction conditions determine the properties of a thin film, and one of the conditions is a temperature of a substrate. In most cases, the temperature of a substrate is controlled by adjusting the temperature of a substrate-placing table (hereinafter, referred to as a stage) over which the substrate is placed. A stage on which a heater for controlling the temperature of a substrate is mounted is disclosed in the patent documents 1 and 2. A resistor serving as the heater is sandwiched by two insulating films and is formed with thermal spraying (thermal metal spraying).

### CITATION LIST

### PATENT LITERATURE

Patent Literature 1: Japanese Patent No. 5876992
Patent Literature 2: Japanese Translation of PCT International Application Publication No. 2012-090782

### SUMMARY OF INVENTION

### PROBLEMS TO BE SOLVED BY THE INVENTION

An object of an embodiment according to the present invention is to provide a stage for precisely controlling a temperature of a substrate and a manufacturing method thereof. Alternatively, an object of an embodiment according to the present invention is a film-forming apparatus or a film-processing apparatus including the stage.

### SOLUTION TO SOLVE THE PROBLEMS

An embodiment according to the present invention is a stage for placing a substrate. The stage includes a base material and a heater layer over the base material. The heater layer includes a first insulating film, a heater wire over the first insulating film, and a second insulating film over the heater wire. The heater wire includes a metal selected from tungsten, nickel, chromium, cobalt and molybdenum.

An embodiment according to the present invention is a film-processing apparatus. The film-processing apparatus includes a chamber, an inlet tube for supplying a gas into the chamber, an exhaust device for reducing a pressure in the chamber, and a stage for placing a substrate. The stage includes a base material and a heater layer over the base material. The heater layer includes a first insulating film, a heater wire over the first insulating film, and a second insulating film over the heater wire. The heater wire includes a metal selected from tungsten, nickel, chromium, cobalt and molybdenum.

An embodiment according to the present invention is a manufacturing method of a stage for placing a substrate. The manufacturing method includes forming a first insulating film over a base material with a thermal spraying method, processing a metal film into a wire shape, the metal film including a metal selected from tungsten, nickel, chromium, cobalt. and molybdenum, arranging the processed metal film over the first insulating film, and forming a second insulating film over the metal film with a thermal spraying method.

An embodiment according to the present invention is a film-forming apparatus. The film-forming apparatus includes a chamber, an inlet tube for supplying a gas into the chamber, an exhaust device for reducing a pressure in the chamber, and a stage for placing a substrate. The stage includes a base material and a heater layer over the base material. The heater layer includes a first insulating film, a heater wire over the first insulating film, and a second insulating film over the heater wire. The heater wire includes a metal selected from tungsten, nickel, chromium, cobalt and molybdenum.

### BRIEF DESCRIPTION OF DRAWINGS

FIG. 1 is a drawing showing a structure of a film-processing apparatus according to an embodiment of the present invention;
FIG. 2A is a schematic cross-sectional view of a stage according to an embodiment of the present invention;
FIG. 2B is a schematic cross-sectional view of a stage according to an embodiment of the present invention;
FIG. 2C is a schematic cross-sectional view of a stage according to an embodiment of the present invention;
FIG. 3 is a schematic perspective view of a stage according to an embodiment of the present invention;
FIG. 4 is a schematic perspective view of a stage according to an embodiment of the present invention;
FIG. 5 is a drawing showing a structure of a film-forming apparatus according to an embodiment of the present invention;
FIG. 6 is a drawing showing a structure of a film-forming apparatus according to an embodiment of the present invention;
FIG. 7 is a drawing showing a structure of a film-forming apparatus according to an embodiment of the present invention;
FIG. 8A is a drawing showing a manufacturing method of a stage according to an embodiment of the present invention;
FIG. 8B is a drawing showing a manufacturing method of a stage according to an embodiment of the present invention;
FIG. 9A is a drawing showing a manufacturing method of a stage according to an embodiment of the present invention;
FIG. 9B is a drawing showing a manufacturing method of a stage according to an embodiment of the present invention;
FIG. 10A is a drawing showing a manufacturing method of a stage according to an embodiment of the present invention;
FIG. 10B is a drawing showing a manufacturing method of a stage according to an embodiment of the present invention;
FIG. 10C is a drawing showing a manufacturing method of a stage according to an embodiment of the present invention;
FIG. 10D is a drawing showing a manufacturing method of a stage according to an embodiment of the present invention;
FIG. 11A is a drawing showing a manufacturing method of a stage according to an embodiment of the present invention;
FIG. 11B is a drawing showing a manufacturing method of a stage according to an embodiment of the present invention;
FIG. 12A is a drawing showing a manufacturing method of a stage according to an embodiment of the present invention;
FIG. 12B is a drawing showing a manufacturing method of a stage according to an embodiment of the present invention;
FIG. 13A is a drawing showing a manufacturing method of a stage according to an embodiment of the present invention; and
FIG. 13B is a drawing showing a manufacturing method of a stage according to an embodiment of the present invention.

### DESCRIPTION OF EMBODIMENTS

Hereinafter, each embodiment of the present invention is explained with reference to the drawings. The invention can be implemented in a variety of different modes within its concept and should not be interpreted only within the disclosure of the embodiments exemplified below.

The drawings may be illustrated so that the width, thickness, shape, and the like are illustrated more schematically compared with those of the actual modes in order to provide a clearer explanation. However, they are only an example, and do not limit the interpretation of the invention. In the specification and the drawings, the same reference number is provided to an element that is the same as that which appears in preceding drawings, and a detailed explanation may be omitted as appropriate.

In the present invention, when a plurality of films is formed by processing one film, the plurality of films may have functions or rules different from each other. However, the plurality of films originates from a film formed as the same layer in the same process and has the same layer structure and the same material. Therefore, the plurality of films is defined as films existing in the same layer.

### <First Embodiment

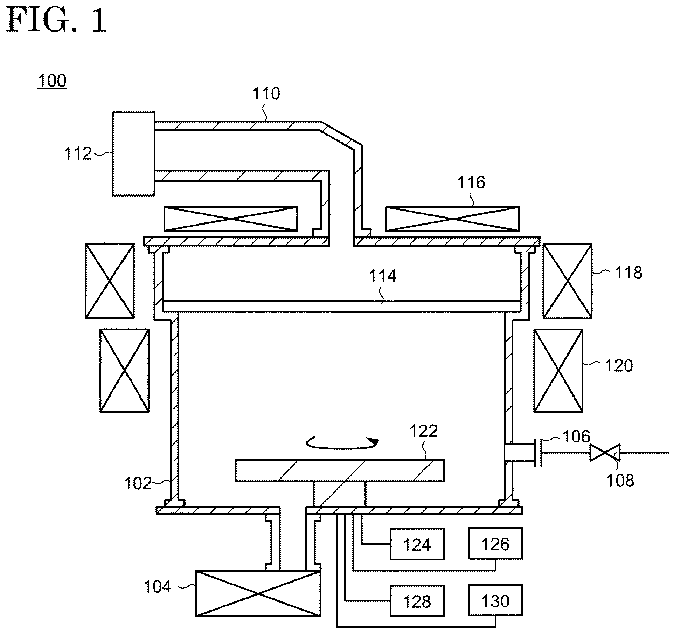

Hereinafter, a stage according to an embodiment of the present invention and a film-processing apparatus including the stage are explained using FIG. 1 to FIG. 4.

### 1. Film-Processing Apparatus

An etching apparatus for dry-etch a variety of films is shown in FIG. 1 as an example of a film-processing apparatus according to the First Embodiment of the present invention. The etching apparatus 100 possesses a chamber 102. The chamber 102 provides a space for etching a film of a conductor, an insulator, or a semiconductor formed over a silicon substrate, a glass substrate, or the like, for example.

An exhaust device 104 is connected to the chamber 102 by which the inside of the chamber 102 can be adjusted to a reduced environment. The chamber 102 is further equipped with an inlet tube 106 for introducing a reaction gas where a reaction gas for etching is introduced into the chamber 102 via a valve 108. As the reaction gas, a fluorine-containing organic compound such as tetrafluorocarbon (CF₄), octafluorocyclobutane (c-C₄F₈), decafluorocyclopentane (c-C₅F₁₀) and hexafluorobutadiene (C₄F₆) is exemplified.

A microwave source 112 may be arranged over the chamber 102 through a waveguide tube 110. The microwave source 112 has an antenna and the like for supplying microwaves and outputs high-frequency microwaves such as microwaves of 2.45 GHz and radio waves (RF) of 13.56 MHz. The microwaves generated by the microwave source 112 are transmitted to an upper portion of the chamber 102 by the waveguide tube 110 and introduced into the chamber 112 through a window 114 including quartz, ceramics, or the like. The reaction gas is plasmatized with the microwaves, and etching of a film proceeds with electrons, ions, and radicals in the plasma.

A stage 122 for placing a substrate is arranged at a lower portion of the chamber 102. The substrate is placed on the stage 122. A power source 124 is connected to the stage 122, and a high-frequency electric power is provided to the stage, by which an electric field generated with microwaves is formed in a direction perpendicular to a stage surface and a substrate surface. Magnets 116, 118, and 120 may be disposed over the chamber 102 or on a side surface of the chamber 102. The magnets 116, 118, and 120 may be a permanent magnetic or an electromagnet having an electromagnet coil. A magnetic component parallel to the surfaces of the stage 122 and the substrate is formed with the magnets 116, 118, and 120, allowing electrons in the plasma to receive a Lorenz force and resonate in association with the electric field generated by the microwaves so that electrons are restrained on the substrate surface. As a result, a high-density plasma can be generated on the substrate surface.

A power source 126 for an electrostatic chuck to fix the substrate to the stage 122, a temperature controller 128 for controlling a temperature of a medium circulated in the stage 122, and a heater power source 130 for controlling a heater wire 154 provided to the state 122 may be connected to the stage 122. As an optional structure, a rotation-controlling device (not illustrated) for rotating the stage 122 may be disposed in the etching apparatus 100.

### 2. Stage

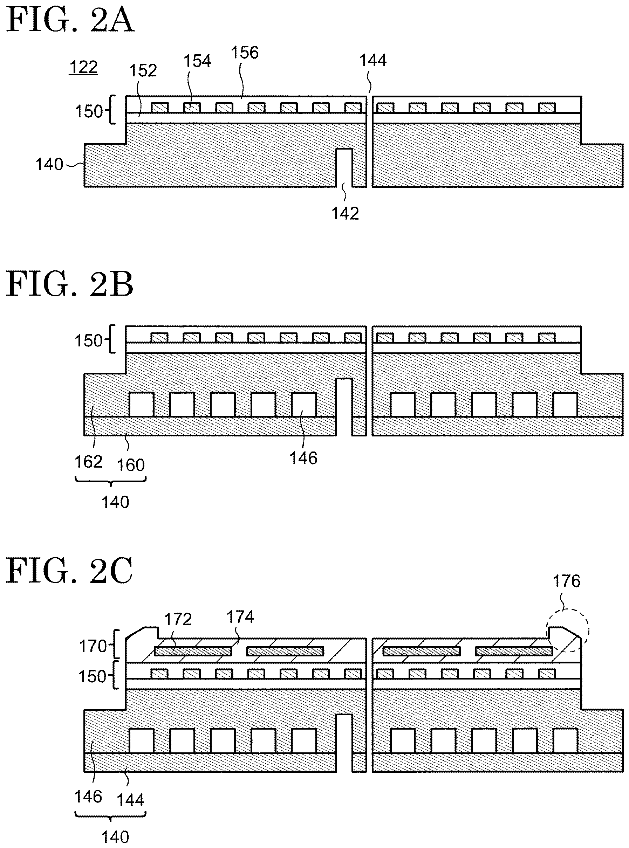

Schematic cross-sectional views of the stage 122 are shown in FIG. 2A, FIG. 2B, and FIG. 2C. As shown in FIG. 2A, the stage 122 has a base material 140 over which a heater layer 150 is provided. A main material of the base material 140 is a metal, and titanium, aluminum, and stainless steel may be used, for example. An opening 142 may be formed at a bottom surface of the base material 140 in order to arrange a temperature sensor. A thermocouple or the like may be utilized as a temperature sensor.

The heater layer 150 mainly possesses three layers. Specifically, the heater layer 150 has a first insulating film 152, the heater wire 154 over the first insulating film 152, and a second insulating film 156 over the heater wire 154 (FIG. 2A). Just one heater wire 154 may be disposed in the heater layer 150, or a plurality of heater wires 154 may be disposed and independently controlled with the heater power source 130. The heater wire 154 is electrically insulated by the first insulating film 152 and the second insulating film 156. The heater wire 154 is heated with the electrical power supplied from the heater power source 130, thereby controlling the temperature of the stage 122.

The first insulating film 152 and the second insulating film 156 may include an inorganic insulator. The inorganic insulator is preferred to have a thermal expansion coefficient close to that of the metal structuring the base material 140, and a difference therebetween may be equal to or more than 0.2×10⁻⁶/K and equal to or less than 2.0×10⁻⁶/K, equal to or more than 0.5×10⁻⁶/K and equal to or less than 1.0×10⁻⁶/K, or equal to or more than 0.7×10⁻⁶/K and equal to or less than 0.9×10⁻⁶/K.

Specifically, aluminum oxide, titanium oxide, chromium oxide, zirconium oxide, magnesium oxide, yttrium oxide, and a composite oxide thereof are represented as the inorganic material. For example, when titanium is used for the base material 140 and aluminum oxide is used for the first insulating film 152 and the second insulating film 156, the thermal expansion coefficients of titanium and aluminum oxide are 8.4×10-⁶/K and 7.7×10-⁶/K, respectively. Since a difference therebetween is small, it is possible to prevent peeling of the heater layer 150 from the base material 140 even when the stage 122 is heated at a high temperature, which results in improvement of durability of the stage 122.

As a material other than an oxide, a carbide such as tungsten carbide-cobalt (WC-Co), tungsten carbide-nickel (WC-Ni), and chromium carbide-nickel-chromium (Cr₃C₂-Ni:Cr) or a nitride such as boron nitride and silicon nitride may be used.

The first insulating film 152 and the second insulating film 156 may be formed with a thermal spraying method. As the thermal spraying method, a localoide spraying method, a plasma spraying method, or a combination thereof may be applied.

The heater wire 154 may include a metal which generates heat when supplied with a current. Specifically, the heater wire 154 may include a metal selected from tungsten, nickel, chromium, cobalt, and molybdenum. The metal may be an alloy containing these metals and may be an alloy containing nickel and chromium or an alloy containing nickel, chromium, and cobalt.

It is preferred that the heater wire 154 be formed by processing, with etching, a metal film or a metal foil independently prepared with a sputtering method, a metal-organic CVD (MOCVD) method, an evaporation method, a printing method, or an electroplating method and then arranging the processed film or foil over the first insulating film 152. This is because it is difficult to secure uniform density, thickness, and width in the entire heater wire 154 when the heater wire 154 is formed with a thermal spraying method, while the heater wire 154 having small values of these physical parameters can be prepared when the metal film or the metal foil is processed with etching. Therefore, it is possible to precisely control the temperature of the stage 122 and reduce a temperature distribution.

In addition, the alloys described above have a higher volume resistivity than a single substance of a metal. Therefore, in the case where the layout of the heater wire 154, that is, the plane shape is the same, the thickness of the heater wire 154 can be increased compared with the case where a simple substance of a metal is employed. Accordingly, a thickness variation of the heater wire 154 can be reduced, by which a small temperature distribution can be realized.

As an optional structure, the stage 122 may have one or a plurality of through holes 144 passing through both of the stage 122 and the base material 140. A helium-supplying tube may be provided to the chamber 102 to allow a gas having a high thermal conductivity, such as helium, to flow in the through hole 144. With this structure, the gas flows between the stage 122 and the substrate, by which the thermal energy of the stage 122 can be efficiently transferred to the substrate.

As shown in FIG. 2B, a trench (flow channel) 146 may be formed in the base material 140 of the stage 122 to circulate a medium for controlling the temperature of the substrate. As the medium, a fluid medium such as water, an alcohol exemplified by isopropanol and ethylene glycol, and silicon oil may be used. In this case, the base material 140 includes a first base material 160 and a second base material 162 and is fabricated by forming the trench 146 in one or both of the first base material 160 and the second base material 162 and then bonding the first base material 160 and the second base material 162 with brazing or the like. The medium may be used either when the stage 122 is cooled or heated.

The temperature of the base material 140 can be controlled by allowing the medium having a temperature which is controlled with the temperature controller 128 (see FIG. 1) to flow in the trench 146. However, a response of the temperature control using a fluid medium is slow, and precise temperature control is relatively difficult. Therefore, it is preferred that the temperature of the base material 140 be roughly controlled with the medium and that the substrate temperature be precisely controlled using the heater wire 154 in the heater layer 150. This method enables not only precise temperature control but also high-speed temperature adjustment of the stage 122.

The stage 122 may be further equipped with an electrostatic chuck 170 as a mechanism to fix the substrate on the stage 122 (FIG. 2C). The electrostatic chuck 170 may have a structure in which an electrostatic chuck electrode 172 is covered with an insulating film 174, for example. Application of a high voltage (several hundred voltages to several thousand voltages) to the electrostatic chuck electrode 172 generates a charge in the electrostatic chuck electrode 172 and a charge which is generated on a back side of the substrate and has a polarity opposite to that of the charge generated in the electrostatic chuck electrode 172, and the substrate is fixed by the coulomb force caused by the charges. As an insulator, a ceramic such as aluminum oxide, aluminum nitride, and boron nitride may be used. The insulating film 174 may not be completely insulating but may have some degree of conductivity (e.g., resistivity in the order of 10⁹ Ω•cm to 10¹² Ω•cm). In this case, the ceramic described above is doped with a metal oxide such as titanium oxide, zirconium oxide, or hafnium oxide in the insulating film 174. A rib 176 may be formed at a periphery of the electrostatic chuck 170 to determine the position of the substrate.

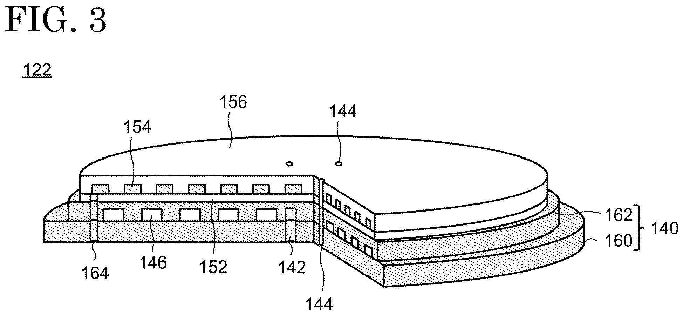

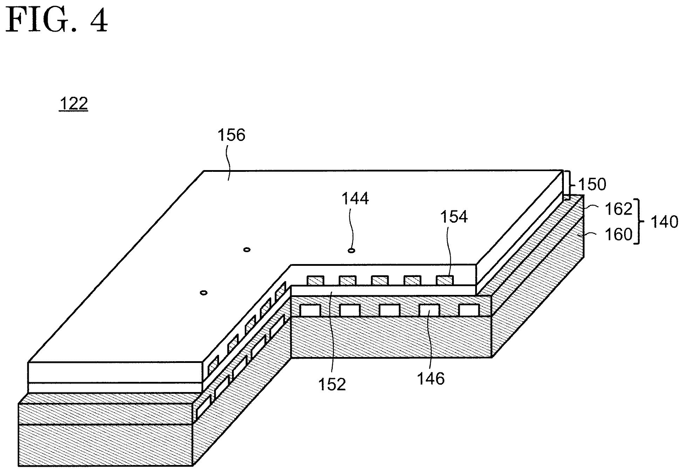

Schematic perspective views of the stage 122 are shown in FIG. 3 and FIG. 4. The stage 122 having the base material 140 provided with the trench 146 is illustrated in FIG. 3 and FIG. 4. The stage 122 may have an opening 164 in the base material 140 for electrical connection to the heater wire 154. The plurality of through holes 144 may be formed. In addition, the stage 122 may not be limited to having a circular shape but may have a rectangular or square shape as shown in FIG. 4. In the latter case, the main surfaces of the base material 140 and the heater layer 150 are rectangular or square, for example. With this structure, not only a circular semiconductor substrate such as a silicon wafer but also a large-size glass substrate for manufacturing a display device or the like can be placed on the stage 122.

As described above, the etching apparatus 100 according to the present embodiment is equipped with the stage 122 having the heater layer 150 sandwiched by the first insulating film 152 and the second insulating film 156 formed with a spraying method. Since the heater wire 154 can be formed by etching a metal film or a metal foil, the thickness, width, and density thereof can be made uniform in the heater wire 154. As a result, the entire surface of the stage 122 can be uniformly heated, allowing precise control and high-speed adjustment of the substrate temperature. Particularly, the formation of the heater wire 154 using an alloy allows the thickness of the heater wire 154 to be increased due to the relatively high volume resistivity thereof. Accordingly, it is possible to further reduce a variation in thickness and width, which contributes to more precise temperature control of a substrate.

### <Second Embodiment>

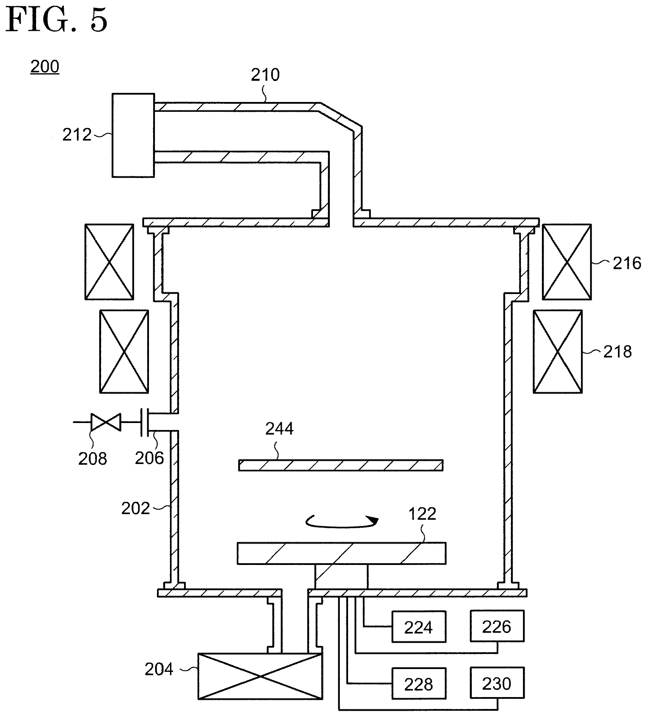

In the present embodiment, a variety of film-forming apparatuses including the stage 122 described in the First Embodiment are explained using FIG. 5 to FIG. 7. Description with respect to the structures the same as those of the First Embodiment may be omitted.

### 1. CVD Apparatus

FIG. 5 is a schematic view of a CVD apparatus 200 as a film-forming apparatus. The CVD apparatus 200 possesses a chamber 202 supplying a space in which a reaction gas is chemically reacted.

An exhaust device 204 is connected to the chamber 202 by which the pressure in the chamber 202 can be reduced. An inlet tube 206 for introducing a reaction gas is further provided to the chamber 202, and the reaction gas for film formation is supplied to the chamber 202 through a valve 208. A variety of gases can be used as the reaction gas, depending on the films to be formed. The gas may be a liquid at a normal temperature. For example, a thin film of silicon, silicon oxide, silicon nitride, or the like can be formed by using silane, dichlorosilane, tetraethoxysilane, and the like. Alternatively, a thin film of a metal such as tungsten and aluminum can be formed by using tungsten fluoride, trimethylaluminum, or the like.

Similar to the etching apparatus 100, a microwave source 212 may be provided over the chamber 202 through a waveguide tube 210. Microwaves generated by the microwave source 212 are introduced into the chamber 202 through the waveguide tube 210. The reaction gas is plasmatized with the microwaves so that chemical reactions of the gas are promoted with a variety of active species included in the plasma, by which the products obtained by the chemical reactions are deposited over a substrate to form a thin film. As an optional structure, a magnet 244 may be arranged in the chamber 202 to increase plasma density. The stage 202 described in the First Embodiment is arranged at the lower portion of the chamber 202, by which deposition of a thin film can be carried out in a state where the substrate is placed on the stage 122. Similar to the etching apparatus 100, magnets 216 and 218 may be further provided on a side surface of the chamber 202.

A power source 224 for supplying a high-frequency electrical power to the stage 122, a power source 226 for the electrostatic chuck 170, a temperature controller 228 for controlling a temperature of a medium circulated in the stage 122, and a heater power source 230 for controlling the heater wire 154 provided in the stage 122 may be further connected to the stage 122. The CVD apparatus 200 may be further equipped with a rotation-controlling device (not illustrated) for rotating the stage 122.

### 2. Sputtering Apparatus

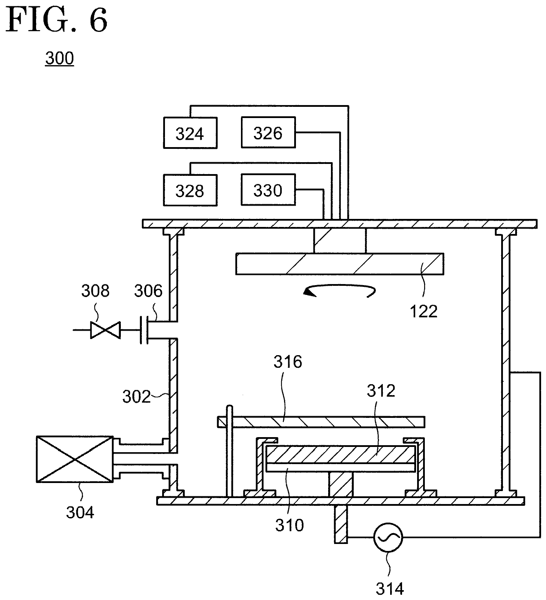

FIG. 6 is a schematic view of a sputtering apparatus 300 as a film-forming apparatus. The sputtering apparatus 300 has a chamber 302 supplying a space for collision of high-speed ions with a target and deposition of target atoms generated by the collision.

An exhaust device 304 for reducing a pressure in the chamber 302 is connected to the chamber 302. An inlet tube 306 for supplying a sputtering gas such as argon and a valve 308 are provided to the chamber 302.

A target stage 310 functioning as a cathode is arranged at the lower portion of the chamber 302 to hold a target 312 including a material to be deposited, over which the target 312 is placed. A high-frequency power source 314 is connected to the target stage 310, and plasma is generated in the chamber 302 with the high-frequency power source 314.

The stage 122 described in the First Embodiment may be arranged at the upper portion of the chamber 302. In this case, formation of a thin film proceeds in a state where a substrate is placed under the stage 122. Similar to the etching apparatus 100 and the CVD apparatus 200, a power source 324 for supplying a high-frequency electric power to the stage 122, a power source 326 for the electrostatic chuck 170, a temperature controller 328, and a heater power source 330 may be further connected to the stage 122. As an optional structure, a rotation-controlling device (not illustrated) for rotating the stage 122 may be provided to the sputter apparatus 300.

Argon ions accelerated by the plasma generated in the chamber 302 collide with the target 312, thereby sputtering the atoms in the target 312. The sputtered atoms fly to the substrate placed under the stage 122 and are deposited while a shutter 316 is opened.

In the present embodiment, a structure is demonstrated where the stage 122 and the target stage 310 are respectively arranged at the upper portion and the lower portion of the chamber 302. However, the present embodiment is not limited thereto, and the sputtering apparatus 300 may be configured so that the target is placed over the stage 122. Alternatively, the stage 122 may be arranged so that a main surface of the substrate is perpendicular to the horizontal plane while the target stage 310 is disposed to oppose the main surface.

### 3. Evaporation Apparatus

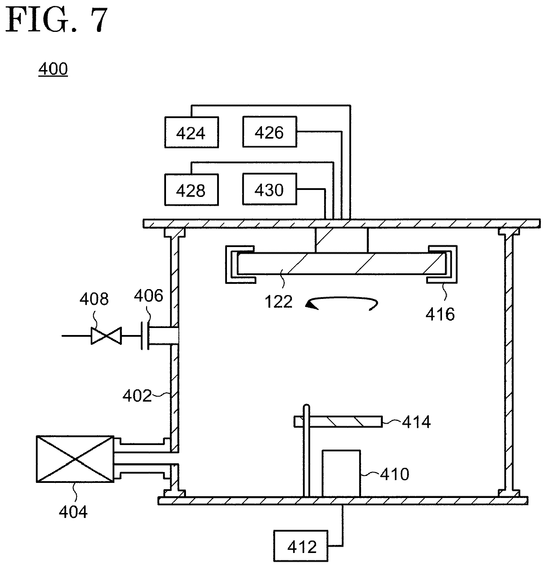

FIG. 7 is a schematic view of an evaporation apparatus 400 as a film-forming apparatus. The evaporation apparatus 400 has a chamber 402 supplying a space to evaporate a material in an evaporation source 410 and deposit the evaporated material on a substrate.

An exhaust device 404 for adjusting the inside of the chamber 402 to a high vacuum is connected to the chamber 402. The chamber 402 is equipped with an inlet tube 406 for returning the internal pressure of the chamber 402 to an atmospheric pressure, and an inert gas such as nitrogen or argon is introduced into the chamber 402 via a valve 408.

The stage 122 described in the First Embodiment may be arranged at the upper portion of the chamber 402. Deposition of a material proceeds in a stage where a substrate is placed under the stage 122. Similar to the etching apparatus 100, the CVD apparatus 200, and the sputtering apparatus 300, a power source 424 for the electrostatic chuck 170, a temperature controller 426, and a heater power source 428 may be connected to the stage 122. A rotation-controlling device 430 may be further provided to the evaporation apparatus 400 as an optional structure. The stage 122 may further include a mask holder 416 for fixing a metal mask between the substrate and the evaporation source 410, by which the metal mask can be arranged at a vicinity of the substrate so that opening portions of the metal mask overlap with the regions where the material is to be deposited.

The evaporation source 410 is placed on the lower side of the chamber 402, and the material to be evaporatively deposited is charged in the evaporation source 410. A heater for heating the material is provided to the evaporation source 410 and is controlled with a controlling device 412. The inside of the chamber 402 is adjusted to a high vacuum using the exhaust device 404, and evaporative deposition is started by heating the evaporation source 410 to vaporize the material. A shutter 414 is opened when the evaporation rate becomes constant, thereby starting deposition of the material on the substrate.

As described above, the film-forming apparatuses such as the CVD apparatus 200, the sputtering apparatus 300, and the evaporation apparatus 400 may have the stage 122 explained in the First Embodiment. Therefore, the temperature of the substrate can be precisely controlled and adjusted at a high responsiveness, which facilitates control of the physical properties of the formed thin films.

### <Third Embodiment>

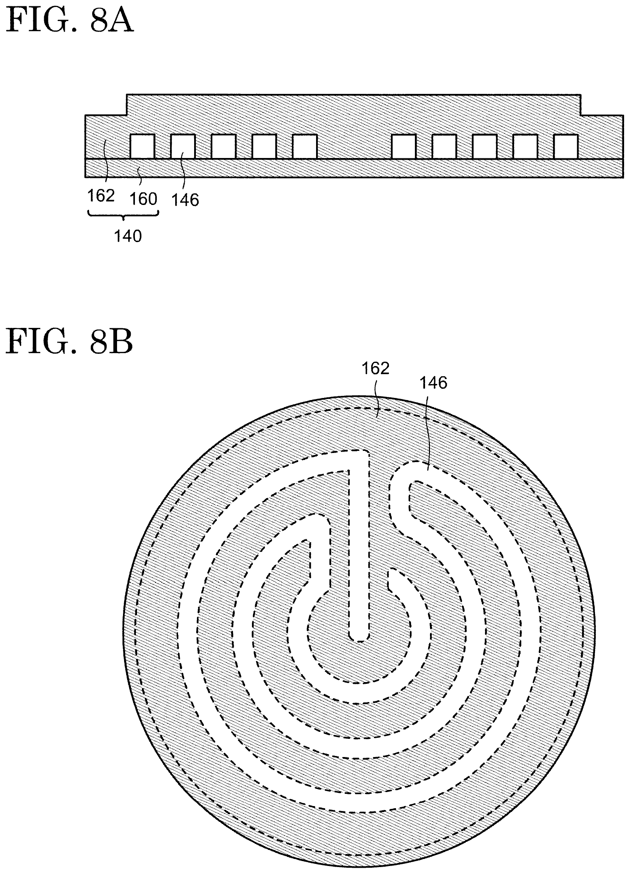

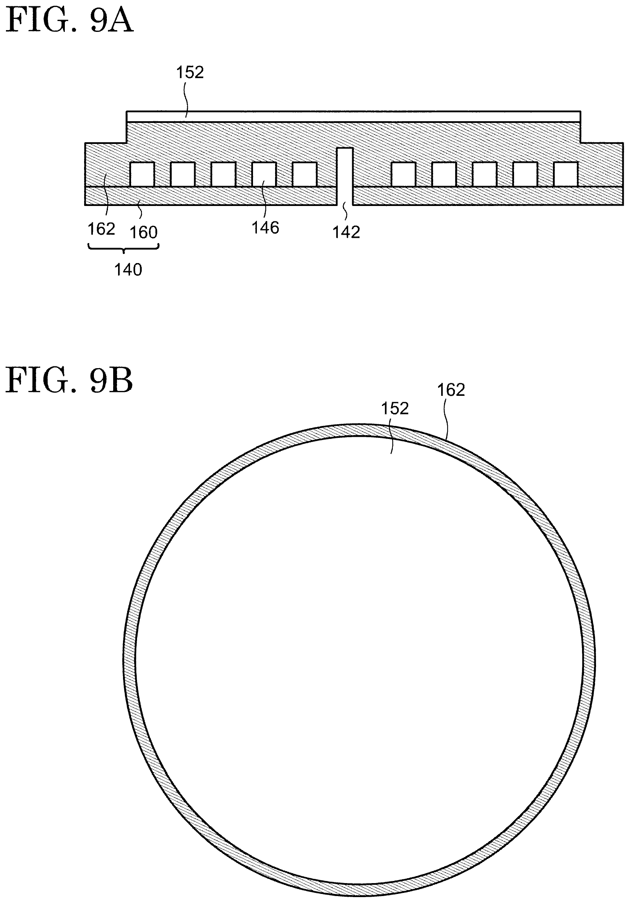

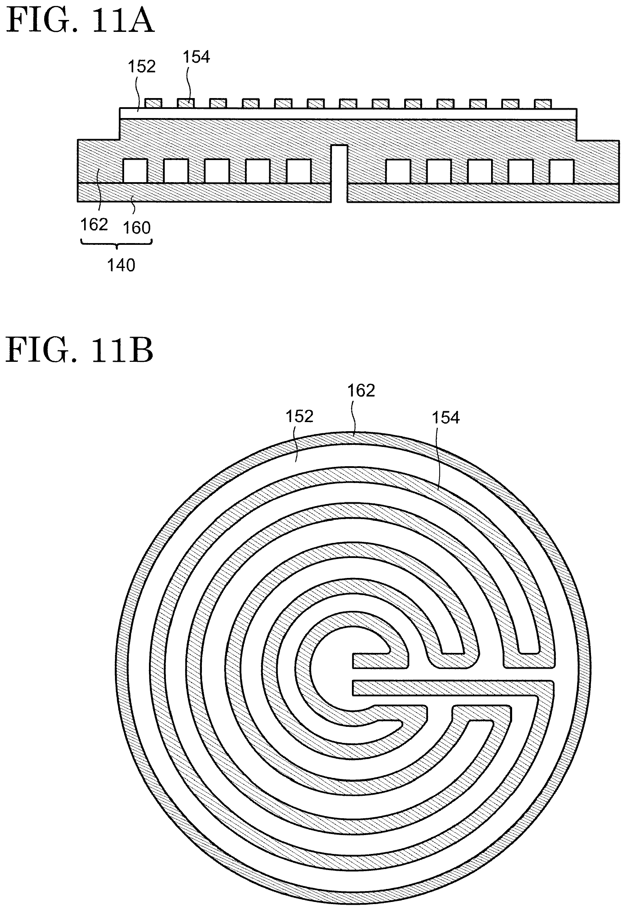

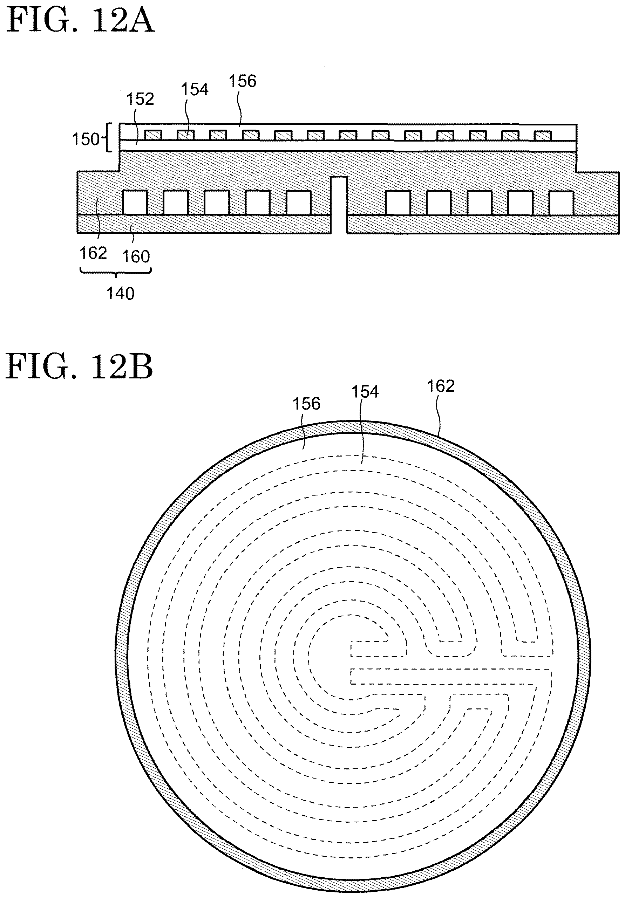

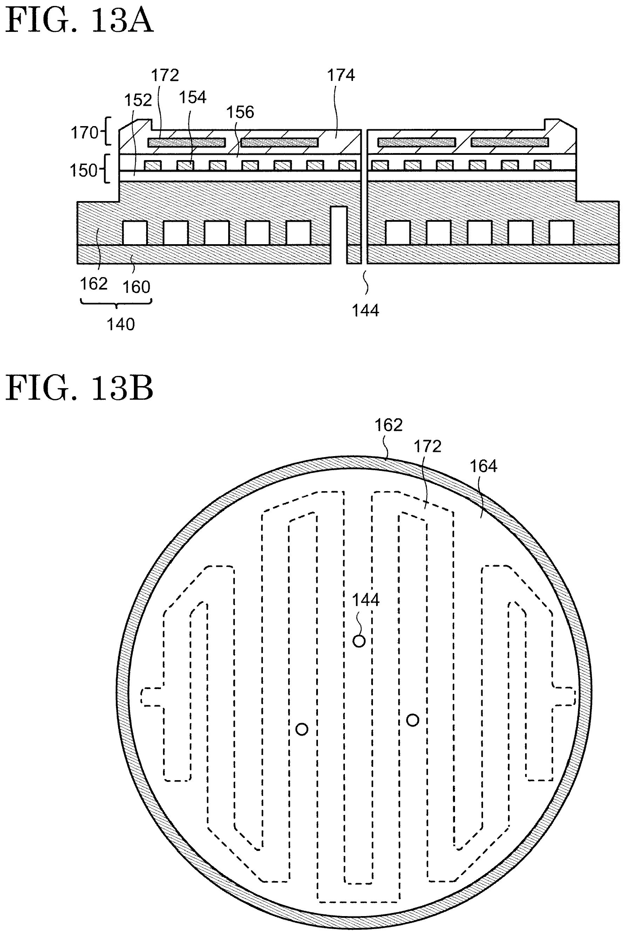

In the present embodiment, a manufacturing method of the stage 122 described in the First Embodiment is explained using FIG. 8A to FIG. 12B. In the present embodiment, a manufacturing method of the stage 122 illustrated in FIG. 2C is explained. FIG. 8A. FIG. 9A. FIG. 11A. FIG. 12A. and FIG. 13A are schematic cross-sectional views of the stage 122 whereas FIG. 8B, FIG. 9B, FIG. 11B, FIG. 12B, and FIG. 13B are schematic top views of the stage 122. Description with respect to the structures the same as those of the First and Second Embodiments may be omitted.

First. the base material 140 having the trench 146 is fabricated. For example, the second base material 162 containing titanium is machined to form the trench 146 for circulating a medium. One or a plurality of trenches 146 may be formed. When a plurality of trenches 146 is formed, the mediums circulated in the plurality of trenches 146 may be independently controlled. The trench 146 may be formed in one or both of the first base material 160 and the second base material 162. After that, the first base material 160 and the second base material 162 are bonded (FIG. 8A and FIG. 8B). The bonding may be carried out with brazing, for example. As a filler, an alloy containing silver, copper, and zinc, an alloy containing copper and zinc, copper containing a small amount of phosphorus, aluminum or an alloy thereof, an alloy containing titanium, copper, and nickel, an alloy containing titanium, zirconium, and copper, an alloy titanium, zirconium, copper. and nickel, and the like are represented.

Next, the first insulating film 152 is formed over the second base material 162 (FIG. 9A and FIG. 9B). The first insulating film 152 may include an inorganic insulator described in the First Embodiment and may be formed with thermal spraying. As described above, a localoide spraying method or a plasma spraying method can be employed, or these methods may be combined. The formation method of the first insulating film 152 is not limited to thermal spraying, and a sputtering method or the like may be applied. If necessary, the openings 142 and 164 (see FIG. 3) may be formed before or after forming the first insulating film 152.

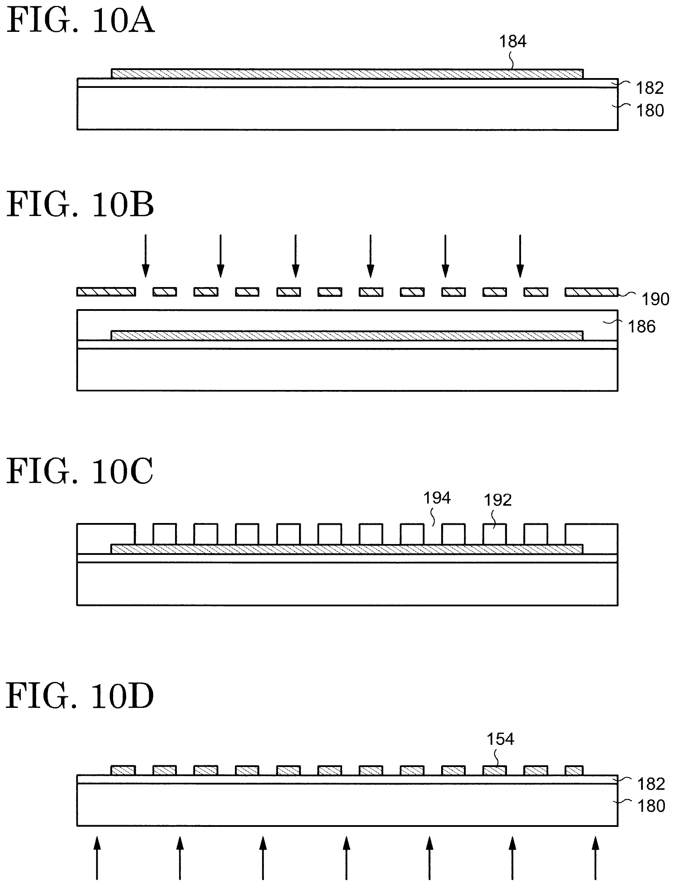

Next, the heater wire 154 is formed over the first insulating film 152. For example, a peeling layer 182 is prepared over a glass substrate 180, over which a metal film (or a metal foil. Hereinafter, a metal film and a metal foil are collectively referred to as a metal foil.) 184 is formed (FIG. 10A). As the peeling layer 182, a polymer material such as a polyimide, a polyamide, a polyester, and a polysiloxane may be used. The metal foil 184 may be formed with an electroplating method, a MOCVD method, a sputtering method, a printing method, an evaporation method, or the like. Alternatively, the metal foil may be formed with a physical stretching process and then placed over the peeling layer 182. A thickness of the metal foil may be 0.1 mm to 2 mm or 0.3 mm to 1 mm, and the metal or alloy described in the First Embodiment may be used as a material thereof.

Next, a resist 186 is formed over the metal foil 184, and light exposure is carried out through a photomask 190 (FIG. 10B). After that, development is performed to form a photoresist 192 having a predetermined pattern over the metal foil 184 (FIG. 10C). Dry etching or wet etching is performed on the regions 194 exposed from the photoresist 192 to remove the regions exposed from the photoresist, by which a pattern for the heater wire 154 is obtained (FIG. 10D). After that, light such as a laser is applied from a backside of the glass substrate 180 (FIG. 10D) to reduce adhesion between the glass substrate 180 and the peeling layer 182 or between the peeling layer 182 and the heater wire 154, and then the heater wire 154 is peeled at the interface therebetween. In order to perform surface planarization, the surface of the metal foil 184 may be polished before the photolithography or the surface of the heater wire 154 may be polished after the photolithography with chemical mechanical polishing. (CMP)

The obtained heater wire 154 is placed over the first insulating film 152 (FIG. 11A and FIG. 11B). At that time, an adhesive may be provided between the heater wire 154 and the first insulating film 152 to fix the heater wire 154. As the adhesive, an epoxy-based adhesive, a polyimide-based adhesive, a silicone-based adhesive, and the like may be used. A filler of an inorganic compound such as titanium oxide, aluminum oxide, and silicon oxide may be included in the adhesive. Not only one heater wire 154 but also a plurality of heater wires 154 may be disposed.

After that, the second insulating film 156 is formed over the heater wire 154 (FIG. 12A and FIG. 12B). The second insulating film 156 may be formed with the same method as the first insulating film 152 and may have the same material as the first insulating film 152. The heater layer 150 is formed by the processes described above.

Finally, the electrostatic chuck 170 is disposed over the heater layer 150 as an optional structure (FIG. 13A and FIG. 13B). The electrostatic chuck 170 may be bonded to the heater layer 150 by bonding to the second insulating film 156 using an adhesive, for example. After that, the through hole 144 may be formed, if necessary.

Through the aforementioned processes, the stage 122 can be fabricated. As described above, the heater wire 154 having a uniform thickness and density can be formed using a metal foil as a starting material. In addition, the heater wire 154 with a uniform width can be formed because the heater wire 154 is formed by processing the metal foil with etching, particularly dry etching. Therefore. it is possible to precisely control the temperature of the substrate placed on the stage 122, adjust the temperature at a high responsiveness, and further reduce a temperature distribution. Accordingly, the use of the stage 122 according to an embodiment of the present invention enables precise control of the structures and properties of a variety of thin films formed or processed over a substrate.

The aforementioned modes described as the embodiments of the present invention can be implemented by appropriately combining with each other as long as no contradiction is caused. Furthermore, any mode which is realized by persons ordinarily skilled in the art through the appropriate addition, deletion, or design change of elements or through the addition, deletion, or condition change of a process is included in the scope of the present invention as long as they possess the concept of the present invention.

It is properly understood that another effect different from that provided by the modes of the aforementioned embodiments is achieved by the present invention if the effect is obvious from the description in the specification or readily conceived by persons ordinarily skilled in the art.

### EXPLANATION OF REFERENCE NUMERAL

100: Etching apparatus, 102: Chamber, 104: Exhaust device, 106: Inlet tube, 108: Valve, 110: Waveguide tube, 112: Microwave source, 114: Window, 116: Magnet, 118: Magnet, 120: Magnet, 122: Stage, 124: Power source, 126: Power source, 128: Temperature controller, 130: Heater power source, 140: Base material, 142: Opening, 144: Through hole, 146: Trench, 150: Heater layer, 152: First insulating film, 154: Heater wire, 156: Second insulating film, 160: First base material, 162: Second base material, 164: Opening, 170: Electrostatic chuck, 172: Electrostatic chuck electrode, 174: Film, 176: Rib, 180: Glass substrate, 182: Peeling layer, 184: Metal foil, 186: Resist, 190: Photomask, 192: Photoresist, 194: Region, 200: CVD apparatus, 202: Chamber, 204: Exhaust device, 206: Inlet tube, 208: Valve, 210: Waveguide tube, 212: Microwave source, 216: Magnet, 218: Magnet, 224: Power source, 226: Power source, 228: Temperature controller, 230: Heater power source, 244: Magnet, 300: Sputtering apparatus, 302: Chamber, 304: Exhaust device, 306: Inlet tube, 308: Valve, 310: Target stage, 312: Target, 314: High-frequency power source, 316: Shutter, 324: Power source, 326: Power source, 328: Temperature controller, 330: Heater power source, 400: Evaporation apparatus, 402: Chamber, 404: Exhaust device, 406: Inlet tube, 408: Valve, 410: Evaporation source, 412: Controlling apparatus, 414: Shutter, 416: Mask holder, 424: Power source, 426: Temperature controller, 428: Heater power source, 430: Rotation-controlling device

## Claims

1. A stage for placing a substrate, the stage comprising:
a base material; and
a heater layer over the base material, the heater layer co mprising:
a first insulating film;
a heater wire over the first insulating film, the heater wire including one or more metals selected from tungsten, nickel, chromium, cobalt and molybdenum; and
a second insulating film over the heater wire.

2. The stage according to claim 1,
wherein the base material includes titanium, and
wherein the first insulating film and the second insulating film include aluminum oxide.

3. The stage according to claim 1,
wherein the base material has a trench configured so that a fluid flows therein.

4. The stage according to claim 1, further comprising an electrostatic chuck over the heater layer.

5. A manufacturing method of a stage for placing a substrate, the method comprising:
forming a first insulating film over a base material with a thermal spraying method;
processing a metal film into a wire shape, the metal film including a metal selected from tungsten, nickel, chromium, cobalt. and molybdenum;
arranging the processed metal film over the first insulating film; and
forming a second insulating film over the metal film with a thermal spraying method.

6. The manufacturing method according to claim 5,
wherein the base material includes titanium, and
wherein the first insulating film and the second insulating film include aluminum oxide.

7. The manufacturing method according to claim 5,
wherein the base material has a trench configured so that a fluid flows therein.

8. The manufacturing method according to claim 5, further comprising arranging an electrostatic chuck over the second insulating film.
